(19) Europäisches Patentamt / European Patent Office / Office européen des brevets

(11) **EP 2 811 533 A1**

(12) **EUROPEAN PATENT APPLICATION**
published in accordance with Art. 153(4) EPC

(43) Date of publication:
**10.12.2014 Bulletin 2014/50**

(51) Int Cl.:
*H01L 31/042* (2014.01)  *H02H 3/00* (2006.01)
*G01R 31/26* (2014.01)

(21) Application number: **13743095.5**

(22) Date of filing: **24.01.2013**

(86) International application number:
**PCT/JP2013/051437**

(87) International publication number:
**WO 2013/115056 (08.08.2013 Gazette 2013/32)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **30.01.2012 JP 2012016811**

(71) Applicant: **JX Nippon Oil & Energy Corporation
Chiyoda-ku
Tokyo 100-8162 (JP)**

(72) Inventors:
• **YOSHIDOMI Masanobu
Nagoya-shi
Aichi 465-0092 (JP)**
• **ISHII Takafumi
Tokyo 100-8162 (JP)**

(74) Representative: **Grünecker, Kinkeldey,
Stockmair & Schwanhäusser
Leopoldstrasse 4
80802 München (DE)**

(54) **SOLAR CELL UNIT AND SOLAR CELL MODULE**

(57) A photovoltaic unit comprising photovoltaics for generating power by utilizing solar light and a bypass diode connected in parallel with the photovoltaics further comprises a reaction element adapted to react to a current flowing therethrough and connected in parallel with the photovoltaics and bypass diode and a blocking element connected in series with the photovoltaics. The reaction element is constructed such as to react to a current flowing therethrough when no current flows through the bypass diode while a reverse voltage is applied to the photovoltaics. The blocking element blocks a current of the photovoltaics according to the reaction of the reaction element.

Fig.2

EP 2 811 533 A1

**Description**

**Technical Field**

The present invention relates to a photovoltaic unit and a photovoltaic module.

**Background Art**

In photovoltaic units which generate power by utilizing solar light in general, there are cases where reverse voltages are applied to photovoltaics under the influence of variations in their characteristics and fluctuations in solar radiation intensity, for example, and may increase to such an extent as to heat and eventually damage the photovoltaics. Therefore, some of the conventional photovoltaic units have been known to connect a bypass diode in parallel with photovoltaics, so as to inhibit excessive reverse voltages from being applied to the photovoltaics.

For such photovoltaic units, a technique for detecting open-mode failures of bypass diodes has been developed as disclosed in the following Patent Literature 1, for example. The inspection device disclosed in Patent Literature 1 shields photovoltaics from light with a shielding plate and detects the temperature of the shielded part in the photovoltaics by thermal paper integrated with the shielding plate. When hot-spot heat generation is detected in the shielded part of the photovoltaics, it is decided that no current flows through the bypass diode, from which it is determined that the bypass diode is in an open-mode failure.

**Citation List**

**Patent Literature**

Patent Literature 1: Japanese Patent Application Laid-Open No. 2001-024204

**Summary of Invention**

**Technical Problem**

However, while it is necessary for the above-mentioned technique to shield the photovoltaics from light in order to detect the open-mode failure of the bypass diode as in the foregoing, the photovoltaics is typically installed at a high place such as a roof, which makes the operation cumbersome in practice and unsuitable for daily inspections in terms of safety and cost.

From the following reason, it may become difficult for the above-mentioned technique to determine whether or not the bypass diode fails. That is, even when the bypass diode is not in the open-mode failure, there is a case where a reverse voltage is applied to some extent to the photovoltaics shielded from light, whereby the heating of the photovoltaics is detected. The extent of the heating depends on the solar radiation intensity at the time, the state of light shielding, the current density of the photovoltaics, the heat dissipation state of the photovoltaics, the shunt resistance component of the photovoltaics, and the like and cannot be expected unconditionally. This makes it very hard to distinguish between the heating in a normal range and that caused by failures of the bypass diode, whereby the open-mode failure of the bypass diode may not be detected accurately.

Furthermore, when the bypass diode is in the open-mode failure, prompt handling is needed in order to prevent the photovoltaics from heating and breaking. However, while being unable to detect the failure accurately and expected to delay the handling, the above-mentioned technique may determine that a normally functioning bypass diode is in a failure and handle it accordingly, thus unnecessarily lowering or suppressing the power generation capacity of the photovoltaics.

In view of the foregoing circumstances, it is an object of the present invention to provide a photovoltaic unit and photovoltaic module which can easily improve their reliability while securing a power generation capacity.

**Solution to Problem**

For achieving the above-mentioned object, the photovoltaic unit in accordance with one aspect of the present invention is a photovoltaic unit comprising photovoltaics for generating power by utilizing solar light and a bypass diode connected in parallel with the photovoltaics, the photovoltaic unit further comprising a reaction element adapted to react to a current flowing therethrough and connected in parallel with the photovoltaics and bypass diode and a blocking element connected in series with the photovoltaics, the reaction element being constructed such as to react to a current flowing therethrough when no current flows through the bypass diode while a reverse voltage is applied to the photovoltaics, the blocking element blocking a current of the photovoltaics according to the reaction of the reaction element. By "a reverse voltage is applied to the photovoltaics" is meant a state where the positive electrode of the photovoltaics has a potential lower than that of the negative electrode (the same hereinafter).

In this photovoltaic unit, the bypass diode can keep high reverse voltages from being applied to the photovoltaics during normal operations. Even when a part of the photovoltaics is shaded and so forth, the current of the photovoltaics is not blocked immediately, and the bypass diode is effective in allowing the other part of the photovoltaics to generate power, whereby the power generation capacity can be restrained from decreasing. Even if a reverse voltage is applied to the photovoltaics when the bypass diode is in the open-mode failure, a current will flow through the reaction element connected in parallel therewith and, according to its reaction, the shielding element will block the current of the photovoltaics, whereby the photovoltaics can be prevented from heating and breaking. That is, without necessitating any specific operation separately, measures against the open-mode failure of the bypass diode are performed automatically, so as to deter damages more serious than the open-mode failure from occurring. Therefore, reliability can easily be improved while securing the power generation capacity.

The reaction element may be a heating element adapted to generate heat in response to a current flowing therethrough, while the blocking element may be a thermal fuse arranged in thermal contact with the heating element. In this case, when a reverse voltage is applied to the photovoltaics upon the open-mode failure of the bypass diode, the heat generated by the heating element in response to the current flowing therethrough can cause the thermal fuse to operate, thereby safely blocking the current of the photovoltaics.

The blocking element may be a switch, and the reaction element may cause the switch to open in response to a current flowing therethrough. In this case, when a reverse voltage is applied to the photovoltaics upon the open-mode failure of the bypass diode, the reaction element can cause the switch to open, thereby safely blocking the current of the photovoltaics.

The reaction element may be constituted by a diode having such an IV curve characteristic that a forward current flows therethrough upon a voltage drop value greater than that in an IV curve characteristic of the bypass diode.

The photovoltaic module in accordance with another aspect of the present invention is a photovoltaic module constituted by a plurality of photovoltaic units connected in series, each of the photovoltaic units comprising photovoltaics for generating power by utilizing solar light and a bypass diode connected in parallel with the photovoltaics, the photovoltaic module further comprising a plurality of reaction elements adapted to react to a current flowing therethrough and connected in parallel with the respective photovoltaics and bypass diodes in the plurality of photovoltaic units and a blocking element connected in series with the plurality of photovoltaic units, the reaction element in each of the plurality of photovoltaic units being constructed such as to react to a current flowing therethrough when no current flows through the bypass diode while a reverse voltage is applied to the photovoltaics, the blocking element blocking a current of the plurality of photovoltaic units according to the reaction of at least one of the plurality of reaction elements.

This photovoltaic module exhibits operations and effects similar to those of the above-mentioned photovoltaic unit. That is, during normal operations, high reverse voltages can be prevented from being applied to the photovoltaics, while the power generation capacity can be restrained from decreasing. Further, even if a bypass diode is in the open-mode failure in at least one of the plurality of photovoltaic units, so that a reverse voltage is applied to the photovoltaics therein, a reaction element can react thereto, whereby the blocking element can completely block the current of the plurality of photovoltaic units. Therefore, reliability can easily be improved while securing the power generation capacity.

The plurality of reaction elements may be heating elements adapted to generate heat in response to a current flowing therethrough, while the blocking element may be a thermal fuse arranged in thermal contact with the plurality of heating elements. In this case, when a reverse voltage is applied to photovoltaics upon the open-mode failure of a bypass diode, the heat generated by the heating element in response to the current flowing therethrough can cause the thermal fuse to operate, thereby safely blocking the current of the plurality of photovoltaics.

The blocking element may be a switch, and the plurality of reaction elements may cause the switch to open in response to a current flowing therethrough. In this case, when a reverse voltage is applied to photovoltaics upon the open-mode failure of a bypass diode, a reaction element can cause the switch to open, thereby safely blocking the current of the plurality of photovoltaics.

The reaction elements in the photovoltaic module may also be constituted by diodes having such an IV curve characteristic that a forward current flows therethrough upon a voltage drop value greater than that in an IV curve characteristic of the bypass diodes.

**Advantageous Effects of Invention**

The present invention can easily improve reliability while securing a power generation capacity.

**Brief Description of Drawings**

Fig. 1 is a structural diagram illustrating the photovoltaic module in accordance with a first embodiment;
Fig. 2 is a schematic circuit diagram of the photovoltaic module of Fig. 1;
Fig. 3 is a perspective view illustrating an element complex of the photovoltaic module of Fig. 1;
Fig. 4 is a set of graphs illustrating IV curve characteristics in a photovoltaic unit in the photovoltaic module of Fig. 1;
Fig. 5 is a set of diagrams for explaining a bypass diode;
Fig. 6 is a structural diagram illustrating the photovoltaic module in accordance with a second embodiment;
Fig. 7 is a schematic circuit diagram of the photovoltaic module of Fig. 6;
Fig. 8 is a schematic circuit diagram illustrating the photovoltaic module in accordance with a third embodiment; and
Fig. 9 is a schematic circuit diagram illustrating the photovoltaic module in accordance with a fourth embodiment.

**Description of Embodiments**

In the following, preferred embodiments of the present invention will be explained in detail with reference to the drawings. In the drawings, the same or equivalent constituents will be referred to with the same signs while omitting their overlapping descriptions.

**First Embodiment**

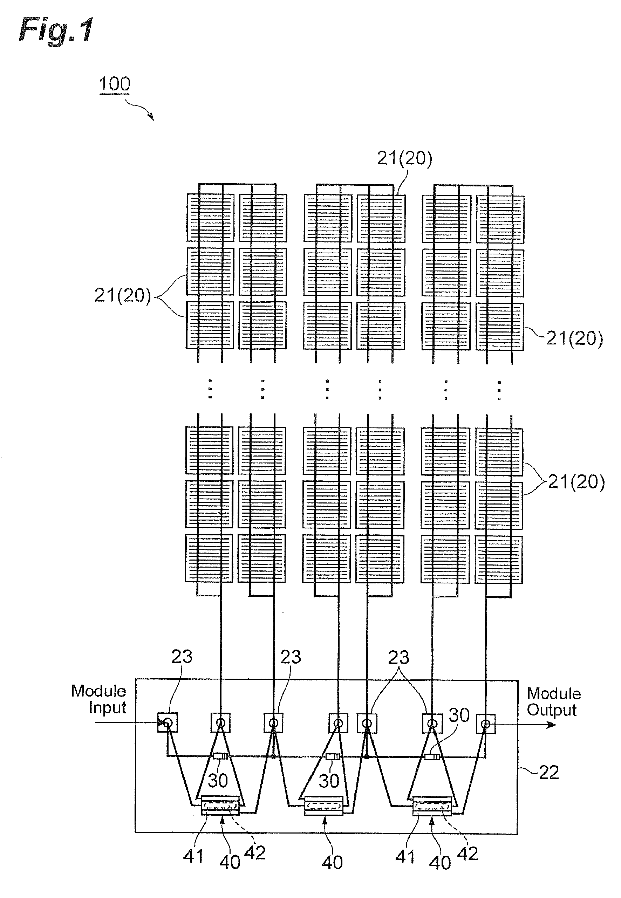

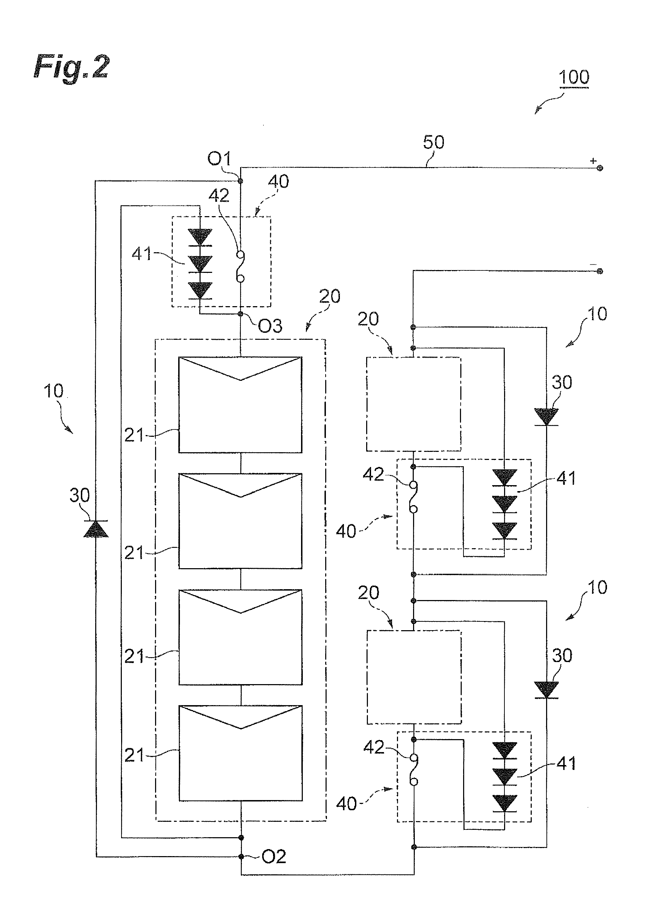

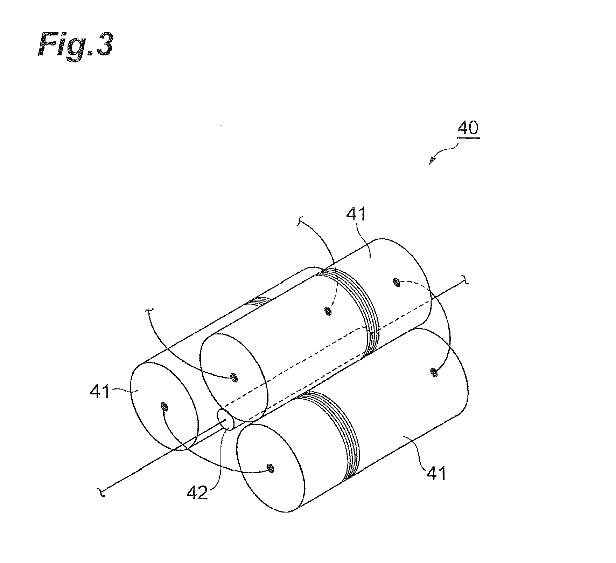

The first embodiment will now be explained. Fig. 1 is a structural diagram illustrating the photovoltaic module in accordance with the first embodiment, Fig. 2 is a schematic circuit diagram of the photovoltaic module of Fig. 1, and Fig. 3 is a schematic view illustrating an element complex. As illustrated in Figs. 1 and 2, a plurality of photovoltaic modules 100 of this embodiment are installed at a high place such as a roof, for example, and connected in series, so as to construct a grid-connected photovoltaic power generation system having an output voltage of 200 V or higher. Such a photovoltaic module 100 comprises a plurality of (3 here) photovoltaic units 10 connected in series.

Each of the plurality of photovoltaic units 10 includes a photovoltaic cluster (photovoltaics) 20, a bypass diode 30, and an element complex 40. The photovoltaic cluster 20 includes a plurality of photovoltaic cells 21 connected in series and generates power by utilizing solar light. The plurality of photovoltaic cells 21 are juxtaposed in a matrix and secured to an aluminum frame while being covered with tempered glass on their light-receiving surface side. The plurality of photovoltaic cells 21 are connected to a plurality of terminals 23 juxtaposed in a row within a junction box 22. For example, crystalline photovoltaic cells each having an output voltage of 0.5 V are used as the photovoltaic cells 21.

The bypass diode 30 is connected in parallel with the photovoltaic cluster 20. For example, a Schottky barrier diode is used as the bypass diode 30 in order to lower the forward voltage and shorten the reverse recovery time. The bypass diode 30 is disposed such that a current flows therethrough when a reverse voltage is applied to the photovoltaic cluster 20, and its forward direction is opposite to the forward direction of equivalent parasitic diodes of the photovoltaic cells 21 within the photovoltaic cluster 20.

Specifically, the cathode side of the bypass diode 30 is connected to the positive electrode side of the photovoltaic cluster 20 on an electric line 50 connecting the photovoltaic clusters 20 in series. The anode side of the bypass diode 30 is connected to the negative electrode side of the photovoltaic cluster 20 on the electric line 50. The bypass diodes 30 are connected to respective pairs of terminals 23 juxtaposed alternately within the junction box 22.

The element complex 40 is a complex comprising heating diodes (heating elements) 41 as reaction elements connected in parallel with the photovoltaic cluster 20 and bypass diodes 30 and a thermal fuse 42 as a blocking element connected in series with the photovoltaic cluster 20 and bypass diodes 30. The element complex 40 is arranged within the junction box 22, such that the heating diodes 41 are connected to a pair of terminals 23 located on one side and at the center among three terminals 23 juxtaposed adjacent to each other, while the thermal fuse 42 is connected to a pair of terminals 23 located on the other side and at the center.

The heating diodes 41 are disposed such that a current flows therethrough when a reverse voltage is applied to the photovoltaic cluster 20, and their forward direction is opposite to the forward direction of equivalent parasitic diodes of the photovoltaic cells 21 in the photovoltaic cluster 20. In particular, the heating diodes 41 are constructed such as to react to a current flowing therethrough (so as to generate heat) when no current flows through the bypass diode 30 while a reverse voltage is applied to the photovoltaic cluster 20. Here, an IV curve (current-voltage curve) characteristic of the heating diodes 41 is set as follows, for example, so that a current flows through the heating diodes 41 when a reverse voltage is applied to the photovoltaic cluster 20 while no current flows through the bypass diode 30.

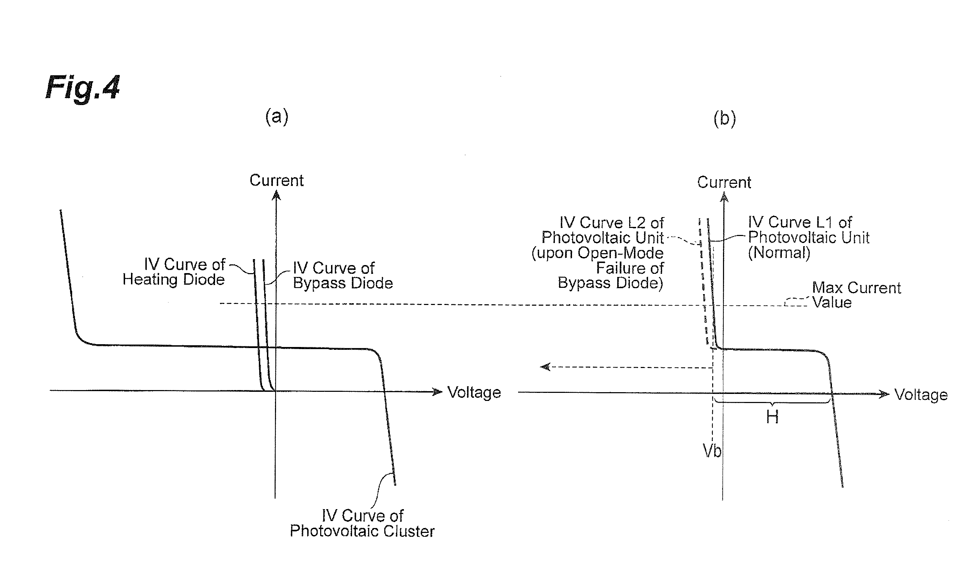

Fig. 4(a) is a graph illustrating IV curve characteristics of individual elements in the photovoltaic unit, while Fig. 4(b) is a graph illustrating a combined IV curve characteristic of the elements in the photovoltaic unit. When the bypass diode 30 functions normally (a current flows through the bypass diode 30), as illustrated in Figs. 4(a) and 4(b), the voltage value in the photovoltaic unit 10 falls within a normal voltage range H, while its lower limit is a voltage drop value Vb at the time when the maximum current value flows through the bypass diode 30. In other words, the largest voltage drop occurs in the photovoltaic unit 10 when the maximum current value flows through the bypass diode 30.

When a voltage drop greater than the voltage drop value Vb is generated, on the other hand, it can be determined that the bypass diode 30 is in an open-mode failure (fails while no currents flows therethrough), so that no current flows through the bypass diode 30. Therefore, as the heating diodes 41, this embodiment employs elements having such an IV curve characteristic that a current flows therethrough when the voltage drop is greater than the voltage drop value Vb. In other words, the heating diodes 41 are constituted by diodes having such an IV curve characteristic that a forward current flows therethrough upon a voltage drop value greater than that in the IV curve characteristic of the bypass diode 30. This allows a current to flow through the heating diodes 41 when no current flows through the bypass diode 30 while a reverse current is applied to the photovoltaic cluster 20.

On the electric line 50, the cathode side of the heating diodes 41 is connected between the positive electrode side of the photovoltaic cluster 20 and a junction O1 of the bypass diode 30. On the electric line 50, the anode side of the heating diodes 41 is connected between the negative electrode side of the photovoltaic cluster 20 and a junction 02 of the bypass diode 30. For example, p-n diodes are used as the heating diodes 41.

According to the heating of the heating diodes 41, the thermal fuse 42 cuts the connection with the photovoltaic cluster 20, thereby blocking the current (charge flow) of the photovoltaic cluster 20. On the electric line 50, the thermal fuse 42 is connected between the junction O1 of the bypass diode 30 and a junction 03 of the heating diodes 41.

The heating diodes 41 and thermal fuse 42 are arranged in thermal contact with each other. Specifically, as illustrated in Fig. 3, a plurality of (3 here) heating diodes 41 are in contact with the thermal fuse 42, so that the heat of the heating diodes 41 can directly transfer to the thermal fuse 42. More specifically, each of the heating diodes 41 and thermal fuse 42 has a columnar outer shape and is provided with leads at both axial end parts thereof. The outer peripheries of the plurality of heating diodes 41 abut against the outer periphery of the thermal fuse 42 while being axially parallel to each other, and they are integrated together.

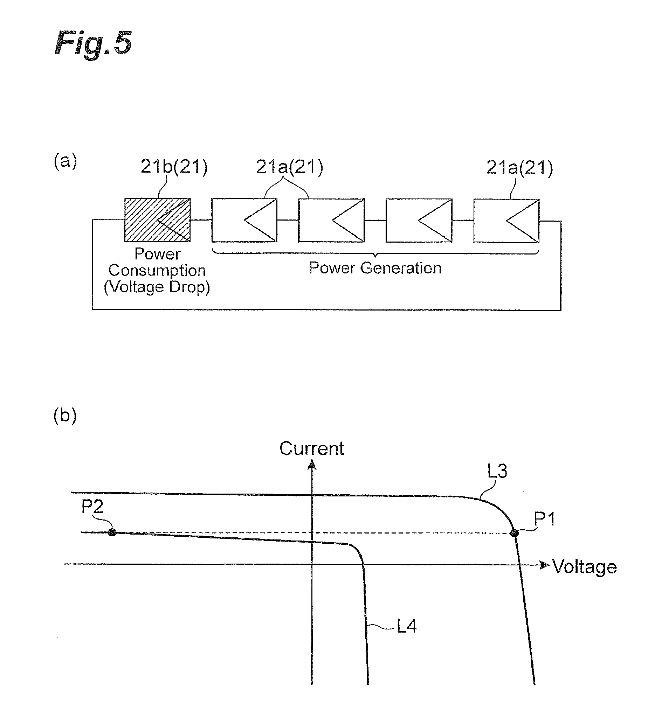

Fig. 5(a) is a structural diagram for explaining a bypass diode, while Fig. 5(b) is a graph illustrating IV curve characteristics of a photovoltaic cluster for explaining the bypass diode. In Fig. 5(b), L3 and L4 illustrate the IV curve characteristics of highly and lowly insolated photovoltaic cells 21a, 21b, respectively. Since a plurality of photovoltaic cells 21 are connected in series as the photovoltaic cluster 20 in the photovoltaic unit 10, a reverse voltage may occur in a part of the photovoltaic cells 21 because of variations in characteristics, differences in solar radiation intensity, and the like among the photovoltaic cells 21.

When highly insolated photovoltaic cells 21a with a favorable amount of solar radiation and a lowly insolated photovoltaic cell 21b with a lower amount of solar radiation are short-circuited as illustrated in Fig. 5(a), their total voltage is 0, whereby their respective operating points are P1, P2 as illustrated in Fig. 5(b). Hence, it is seen that, while the highly insolated photovoltaic cells 21a generate power, the lowly insolated photovoltaic cell 21b consumes the same power as generated and thus has a reverse voltage applied thereto.

Therefore, connecting the bypass diode 30 in parallel with the photovoltaic cluster 20, so as to suppress the voltage loss Vloss of the photovoltaic cluster 20, can prevent the voltage loss Vcell of the lowly insolated photovoltaic cell 21b from greatly exceeding the voltage gain Vg as represented by the following expression (1):

$$\text{Vcell} = \text{Vloss} + \text{Vg} \qquad (1)$$

where

Vcell is the voltage loss of the lowly insolated photovoltaic cell 21b;
Vloss is the voltage loss of the photovoltaic cluster 20; and
Vg is the voltage gain of the photovoltaic cluster 20.

As a result, the bypass diode 30 acts to restrain the reverse voltage of the photovoltaic cells 21 from exceeding the voltage of the photovoltaic cluster 20, whereby the photovoltaic unit 10 can secure high safety. Even when the lowly insolated photovoltaic cell 21b exists in the photovoltaic cluster 20, the bypass diode 30 allows a large current from another photovoltaic cluster 20 to pass therethrough, whereby the amount of power generation of the latter photovoltaic cluster 20 can be maintained. This can reduce the drop in the amount of power generation in the whole system.

When the bypass diode 30 is in the open-mode failure for some reason here, there is a fear of a large voltage being applied to a specific photovoltaic cell 21, thus generating power and damaging the module, which makes it favorable to block currents from flowing through the photovoltaic unit 10 or photovoltaic module 100. When the bypass diode 30 operates normally, on the other hand, in order to secure a power generation capacity, it is preferable to prevent the photovoltaic unit 10 or photovoltaic module 100 from being blocked erroneously and let the bypass diode 30 function securely.

In this regard, even if a reverse voltage is applied to the photovoltaic cluster 20 when the bypass diode 30 operates normally in the photovoltaic unit 10 of this embodiment, as illustrated in Fig. 4(b), the IV curve characteristic L1, which is dominated by the bypass diode 30 and has the normal voltage range H, causes the bypass diode 30 to function so as to prevent currents from flowing through the heating diodes 41. Hence, the heating diodes 41 do not generate heat, so that the thermal fuse 42 does not operate, whereby the photovoltaic unit 10 is not blocked.

When the bypass diode 30 is in the open-mode failure, on the other hand, the IV curve of the photovoltaic unit 10 shifts to the IV curve characteristic L2 dominated by the heating diodes 41. When a reverse voltage is applied to the photovoltaic cluster 20, so that a voltage drop greater than the voltage drop value Vb occurs, a current flows through the heating diodes 41, so as to heat the heating diodes 41, and the resulting heat cuts the thermal fuse 42, thereby completely blocking the current of the photovoltaic unit 10.

Therefore, this embodiment can prevent high reverse voltages from being applied to the photovoltaic cluster 20 and eventually to the photovoltaic cells 21 during normal operations and, even when one of the photovoltaic cells 21 is shaded and so forth, does not immediately block the current of the photovoltaic unit 10, but can effectively utilize the power generation of other photovoltaic clusters 20, thereby restraining the power generation capacity from decreasing.

In addition, the heating diodes 41 can be operated only when the bypass diode 30 is in the open-mode failure, so as to block the current of the photovoltaic unit 10 securely and easily at low cost. As a result, reliability can be improved easily while securing a power generation capacity.

In this embodiment, the thermal fuse 42 completely blocks the current of the photovoltaic unit 10 by utilizing the heating of the heating diodes 41 as mentioned above. Using diodes having a forward voltage higher than that of the bypass diode 30 as the heating diodes 41 and combining them with the thermal fuse 42 can securely block the current only when necessary without using any of special control circuits and switches.

While this embodiment blocks the current of the photovoltaic unit 10 by cutting the thermal fuse 42 as mentioned above, the current of a specific photovoltaic unit 10 in which the bypass diode 30 is in the open-mode failure may be blocked alone such that this photovoltaic unit 10 is separated from the electric line 50. This allows the photovoltaic units 10 other than the specific photovoltaic unit 10 to continue power generation favorably.

Though this embodiment exemplifies a structure in which the thermal fuse 42 cuts one location of the electric line 50 when the bypass diode 30 is in the open-mode failure, a plurality of locations may be cut. This can cut the current of the photovoltaic unit 10 more securely. Though this embodiment explains the photovoltaic unit 10 including the photovoltaic cluster 20 by way of example, the photovoltaic unit 10 may be constituted by a single photovoltaic cell 21.

**Second Embodiment**

The second embodiment will now be explained. This embodiment will be explained mainly in terms of differences from the above-mentioned first embodiment.

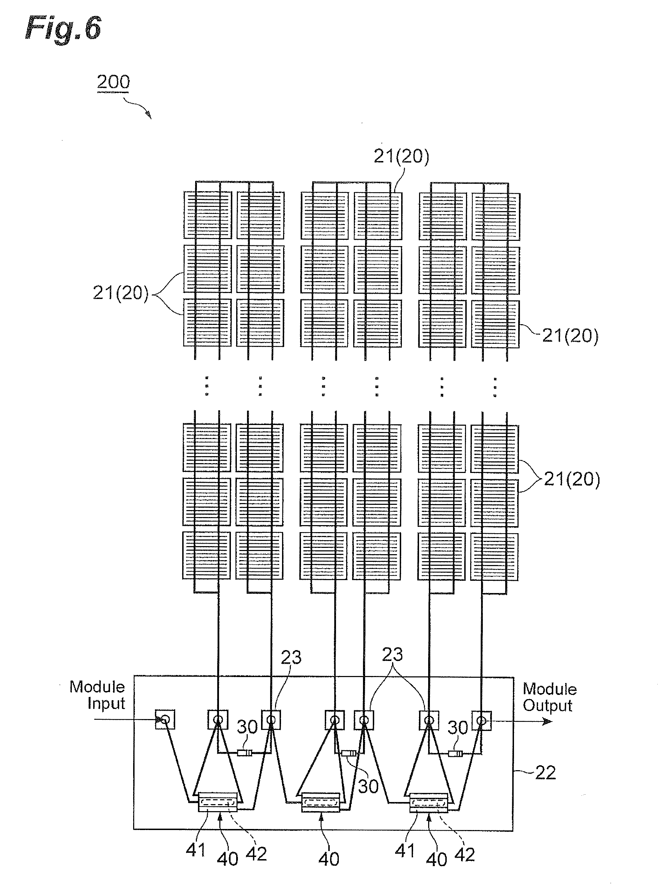

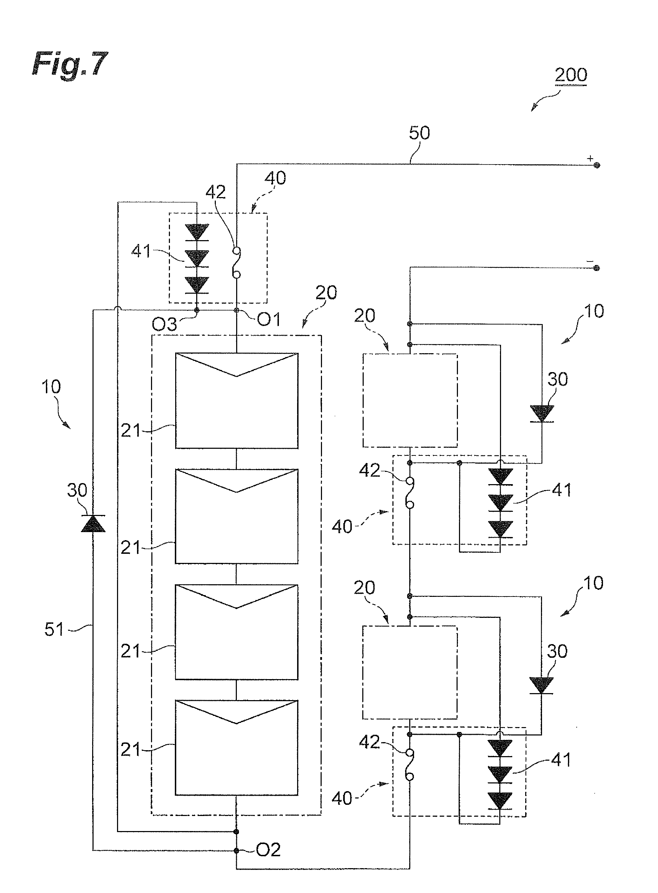

Fig. 6 is a structural diagram illustrating the photovoltaic module in accordance with the second embodiment, while Fig. 7 is a schematic circuit diagram of the photovoltaic module of Fig. 6. As illustrated in Figs. 6 and 7, the photovoltaic module 200 of this embodiment differs from the above-mentioned photovoltaic module 100 (see Figs. 1 and 2) in that the circuit structures of the bypass diode 30 and element complex 40 are changed. That is, while the bypass diode 30 is connected in parallel with the photovoltaic cluster 20 and thermal fuse 42 connected in series in the photovoltaic module 100 illustrated in Figs. 1 and 2, the bypass diode 30 is connected in parallel with the photovoltaic cluster 20 in the photovoltaic module 200 in the second embodiment as illustrated in Figs. 6 and 7.

More specifically, as illustrated in Fig. 6, the bypass diode 30 is connected to a pair of terminals 23 adjacent to each other arranged within a junction box 22. As illustrated in Fig. 7, the cathode side of heating diodes 41 in the element complex 40 is connected to a bypass electric line 51, parallel to the photovoltaic cluster 20, including the bypass diode 30. On the electric line 50, the thermal fuse 42 of the element complex 40 is connected to the side opposite from the photovoltaic cluster 20 with respect to the junction O1 of the bypass diode 30.

Thus constructed embodiment also exhibits the above-mentioned effect of easily improving reliability while securing a power generation capacity. That is, it can prevent high reverse voltages from being applied to the photovoltaic cells 21 and restrain the power generation capacity from decreasing. Further, when a reverse voltage is applied to the photovoltaic cluster 20 while the bypass diode 30 is in the open-mode failure, the current of the photovoltaic unit 10 can be blocked completely.

On the electric line 50, the thermal fuse 42 of this embodiment is connected to the side opposite from the photovoltaic cluster 20 with respect to the junction O1 between the bypass diode 30 and the heating diodes 41. Therefore, upon the open-mode failure of the bypass diode 30, the thermal fuse 42 melts down, thus making it possible to stop the current more securely.

**Third Embodiment**

The third embodiment will now be explained. This embodiment will be explained mainly in terms of differences from the above-mentioned second embodiment.

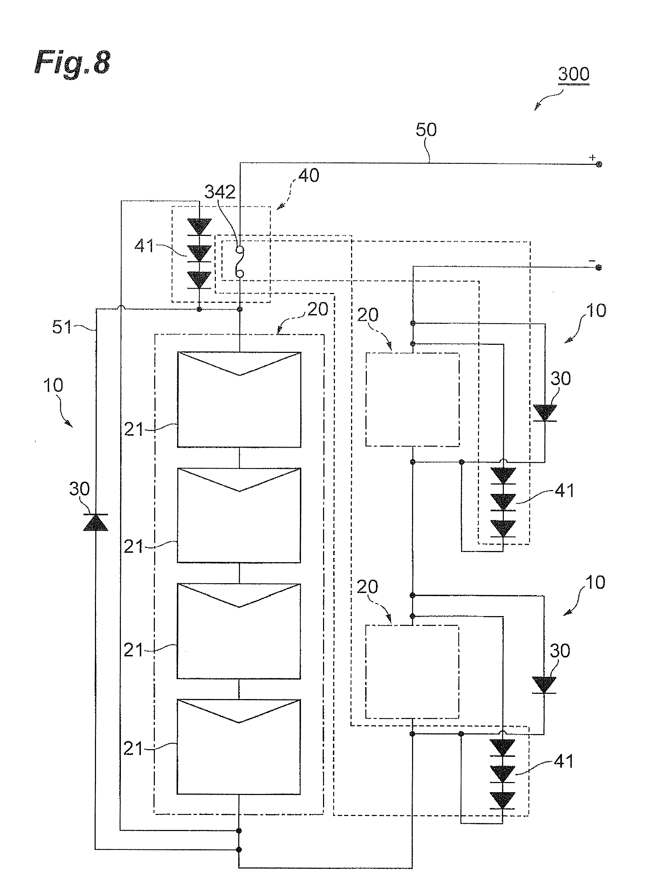

Fig. 8 is a schematic circuit diagram illustrating the photovoltaic module in accordance with the third embodiment. As illustrated in Fig. 8, the photovoltaic module 300 of this embodiment differs from the above-mentioned photovoltaic module 200 (see Fig. 7) in that a plurality of photovoltaic units 10 are equipped with a common thermal fuse 342 in place of a plurality of thermal fuses 42 provided for the respective photovoltaic units 10.

The thermal fuse 342 is connected in series with a plurality of photovoltaic clusters 20 and a plurality of bypass diodes 30. According to the heating of at least one of the plurality of heating diodes 41, the thermal fuse 342 cuts connections with a plurality of photovoltaic units 10, thereby blocking currents of the plurality of photovoltaic units 10. Only one thermal fuse 342 is disposed on the electric line 50 so as to be connected to the side opposite from the photovoltaic cluster 20 with respect to the junction O1 of the bypass diode 30 in one photovoltaic unit 10.

The heating diodes 41 of the plurality of photovoltaic units 10 are in contact with the thermal fuse 342, so that the heat of the heating diodes 41 can directly transfer to the thermal fuse 342. Specifically, the thermal fuse 342 has a columnar outer shape and is provided with leads at both axial end parts thereof. The outer peripheries of the heating diodes 41 in the plurality of photovoltaic units 10 abut against the outer periphery of the thermal fuse 342, while the thermal fuse 342 and the heating diodes 41 are axially parallel to each other, and they are integrated together.

When the bypass diode 30 is in the open-mode failure in at least one photovoltaic unit 10 in the photovoltaic module 300 of this embodiment, so that a reverse voltage is applied to the photovoltaic cluster 20, whereby a voltage drop greater than the voltage drop value Vb occurs, a current flows through the heating diodes 41, thereby heating the heating diodes 41. This cuts the thermal fuse 342, thereby completely blocking currents of the plurality of photovoltaic units 10 and eventually of the whole photovoltaic module 300.

Thus constructed embodiment also exhibits the above-mentioned effect of easily improving reliability while securing a power generation capacity. That is, it can prevent high reverse voltages from being applied to the photovoltaic cells 21 and restrain the power generation capacity from decreasing. Further, when a reverse voltage is applied to the photovoltaic cluster 20 while the bypass diode 30 is in the open-mode failure, currents of the plurality of photovoltaic units 10 can be blocked completely.

As mentioned above, this embodiment allows one thermal fuse 342 to function as a common blocking element in a plurality of photovoltaic units 10 and thus can reduce the number of components and cut cost down.

**Fourth Embodiment**

The fourth embodiment will now be explained. This embodiment will be explained mainly in terms of differences from the above-mentioned first embodiment.

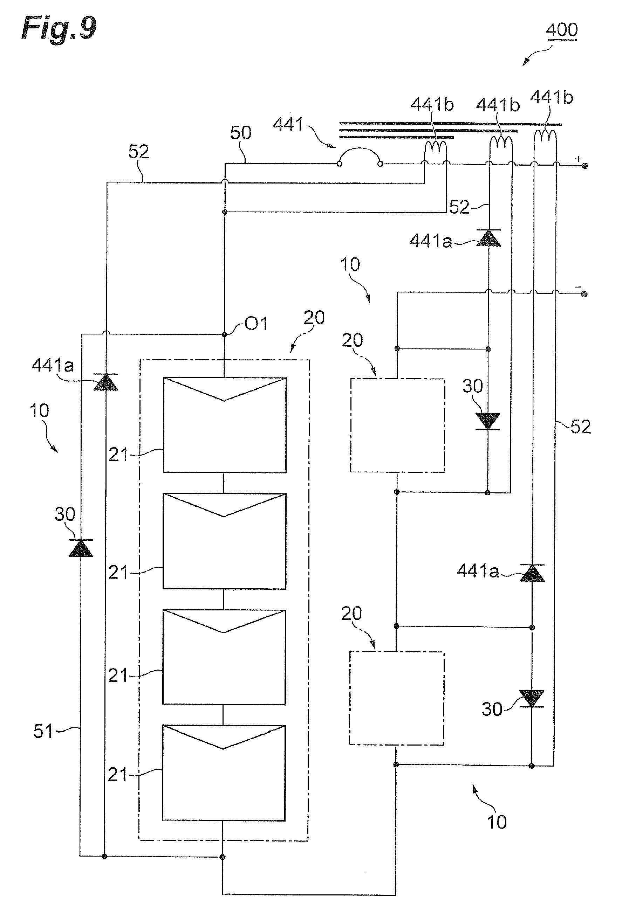

Fig. 9 is a schematic circuit diagram illustrating the photovoltaic module in accordance with the fourth embodiment. As illustrated in Fig. 9, the photovoltaic module 400 of this embodiment differs from the above-mentioned photovoltaic module 100 (see Fig. 2) in that it comprises control diodes 441a and electromagnetic coils 441b as reaction elements in place of the heating diodes 41 and a common electromagnetic switch (switch) 442 for a plurality of photovoltaic units 10 in place of a plurality of thermal fuses 42 provided for the respective photovoltaic units 10.

Each control diode 441a, which is used for controlling a current flow, is connected in parallel with the photovoltaic cluster 20 and bypass diode 30. The forward direction of the control diode 441a is opposite to that of the photovoltaic cluster 20. Here, the control diode 441a is constructed such that a current flows therethrough when no current flows through the bypass diode 30 while a reverse voltage is applied to the photovoltaic cluster 20, and has an IV curve characteristic similar to that of the above-mentioned heating diodes 41, for example.

The cathode side of the control diode 441a is connected to the side opposite from the photovoltaic cluster 20 with respect to the junction O1 of the bypass diode 30 on the electric line 50, while the anode side of the control diode 441a is connected to the bypass electric line 51.

As mentioned above, a Schottky barrier diode having a small forward voltage is typically used as the bypass diode 30, while a p-n junction diode having a forward voltage higher than that in the bypass diode 30 can be used as the control diode 441a in this case. When a p-n junction diode is used as the bypass diode 30, on the other hand, a plurality of p-n junction diodes connected in series can be used as the control diode 441a. These allow the control diode 441a to exhibit the above-mentioned function easily and favorably.

Each electromagnetic coil 441b is connected in series with a control electric line 52, parallel to the photovoltaic cluster 20 and bypass diode 30, including the control diode 441a. The electromagnetic coil 441b, which generates a magnetic force when a current flows therethrough, is disposed on the cathode side of the control diode 441a on the control electric line 52.

The electromagnetic switch 442 is connected in series with a plurality of photovoltaic clusters 20 and a plurality of bypass diodes 30. The electromagnetic switch 442 is normally (usually) closed. On the other hand, the electromagnetic switch 442 is arranged within a magnetic field caused by a plurality of electromagnetic coils 441b and is opened by a magnetic force generated in at least one of the plurality of electromagnetic coils 441b, so as to cut connections with a plurality of photovoltaic units 10, thereby cutting currents of the plurality of photovoltaic units 10. Only one electromagnetic switch 442 is disposed on the electric line 50, so as to be connected to the side opposite from the photovoltaic cluster 20 with respect to a junction 04 of the control diode 441 a in one photovoltaic unit 10.

When the bypass diode 30 is in the open-mode failure in at least one photovoltaic unit 10 in the photovoltaic module 400 of this embodiment, so that a reverse voltage is applied to the photovoltaic cluster 20, whereby a voltage drop greater than the voltage drop value Vb occurs, a current flows through the control diode 441 a and electromagnetic coil 441b, thereby generating a magnetic force in the electromagnetic coil 441b. This opens the electromagnetic switch 442, thereby completely blocking currents of the plurality of photovoltaic units 10 and eventually of the whole photovoltaic module 400.

Thus constructed embodiment also exhibits the above-mentioned effect of easily improving reliability while securing a power generation capacity. That is, it can prevent high reverse voltages from being applied to the photovoltaic cells 21 and restrain the power generation capacity from decreasing. Further, when a reverse voltage is applied to the photovoltaic cluster 20 while the bypass diode 30 is in the open-mode failure, currents of the plurality of photovoltaic units 10 can be blocked completely.

In this embodiment, as mentioned above, the electromagnetic switch 442 is operated by the control diodes 441a and electromagnetic coils 441b, so as to block currents of the plurality of photovoltaic units 10 completely. In this case, using a diode having a forward voltage higher than that of the bypass diode 30 as the control diode 441a can excite the electromagnetic coil 441b only when necessary without using any of special control circuits and switches, so as to block currents. Also, in this case, closing the electromagnetic switch 442 after replacing a failed bypass diode 30 can resume a normal state.

While preferred embodiments are explained in the foregoing, the present invention is not limited thereto but may be modified or applied to others within the scope not changing the gist set forth in each claim.

For example, the number of photovoltaic cells 21 constituting the photovoltaic cluster 20 is not restricted and may be one or more. The numbers of photovoltaic units constituting any of the photovoltaic modules 100, 200, 300, 400 is not limited either and may be one or more.

While the above-mentioned embodiments use the heating diodes 41 as heating elements, other elements such as heating coils and resistors may be used instead. Elements utilizing thermostats and thermistors may be used in place of the thermal fuses 42, 342. While the above-mentioned fourth embodiment opens and closes the electromagnetic switch 442 by the magnetic force of the electromagnetic coils 441b, the switch may be opened and closed by utilizing piezoelectric effects of a piezoelectric element, for example.

The heating diodes 41 and control diodes 441 a in the above-mentioned embodiments are elements having a predetermined IV curve characteristic (i.e., such an IV curve characteristic that a current flows when a voltage drop greater than the voltage drop Vb at the time when the maximum current value flows through the bypass diode 30 is generated in the photovoltaic cluster 20). In other words, the reaction element is constructed such that a current flows when a reverse voltage greater than the maximum reverse voltage at the time when a current flows through the bypass diode 30 is generated in the photovoltaic cluster 20. However, the reaction element is not limited to this but only required to be constructed such as to react to a current flowing therethrough when no current flows through the bypass diode while a reverse voltage is applied to the photovoltaics.

**Industrial Applicability**

The present invention can easily improve reliability while securing a power generation capacity.

**Reference Signs List**

10: photovoltaic unit; 20: photovoltaic cluster (photovoltaics); 30: bypass diode; 41: heating diode (reaction element, heating element); 42, 342: thermal fuse (blocking element); 100, 200, 300, 400: photovoltaic module; 441a: control diode (reaction element); 441b: electromagnetic coil; 442: electromagnetic switch (blocking element, switch)

**Claims**

1.  A photovoltaic unit comprising photovoltaics for generating power by utilizing solar light and a bypass diode connected in parallel with the photovoltaics, the photovoltaic unit further comprising:

a reaction element adapted to react to a current flowing therethrough and connected in parallel with the photovoltaics and bypass diode; and

a blocking element connected in series with the photovoltaics;

wherein the reaction element is constructed such as to react to a current flowing therethrough when no current flows through the bypass diode while a reverse voltage is applied to the photovoltaics; and

wherein the blocking element blocks a current of the photovoltaics according to the reaction of the reaction element.

2. A photovoltaic unit according to claim 1, wherein the reaction element is a heating element adapted to generate heat in response to a current flowing therethrough; and

wherein the blocking element is a thermal fuse arranged in thermal contact with the heating element.

3. A photovoltaic unit according to claim 1, wherein the blocking element is a switch; and

wherein the reaction element causes the switch to open in response to a current flowing therethrough.

4. A photovoltaic unit according to one of claims 1 to 3, wherein the reaction element is constituted by a diode having such an IV curve characteristic that a forward current flows therethrough upon a voltage drop value greater than that in an IV curve characteristic of the bypass diode.

5. A photovoltaic module constituted by a plurality of photovoltaic units connected in series, each of the photovoltaic units comprising photovoltaics for generating power by utilizing solar light and a bypass diode connected in parallel with the photovoltaics, the photovoltaic module further comprising:

a plurality of reaction elements adapted to react to a current flowing therethrough and connected in parallel with the respective photovoltaics and bypass diodes in the plurality of photovoltaic units; and

a blocking element connected in series with the plurality of photovoltaic units;

wherein the reaction element in each of the plurality of photovoltaic units is constructed such as to react to a current flowing therethrough when no current flows through the bypass diode while a reverse voltage is applied to the photovoltaics; and

wherein the blocking element blocks a current of the plurality of photovoltaics units according to the reaction of at least one of the plurality of reaction elements.

6. A photovoltaic module according to claim 5, wherein the plurality of reaction elements are heating elements adapted to generate heat in response to a current flowing therethrough; and

wherein the blocking element is a thermal fuse arranged in thermal contact with the plurality of heating elements.

7. A photovoltaic module according to claim 6, wherein the blocking element is a switch; and

wherein the plurality of reaction elements cause the switch to open in response to a current flowing therethrough.

8. A photovoltaic module according to one of claims 5 to 7, wherein the reaction elements in the photovoltaic module are constituted by diodes having such an IV curve characteristic that a forward current flows therethrough upon a voltage drop value greater than that in an IV curve characteristic of the bypass diodes.

# Fig.1

100

21(20)

21(20)

21(20)

21(20)

23            23            23

Module
Input

Module
Output

30

22

41  40 42        40        41  40 42

*Fig.2*

*Fig.3*

# Fig.4

(a)

(b)

Current

IV Curve of
Heating Diode
IV Curve of
Bypass Diode

Voltage

IV Curve of
Photovoltaic Cluster

Current

IV Curve L2 of
Photovoltaic Unit
(upon Open-Mode
Failure of
Bypass Diode)

IV Curve L1 of
Photovoltaic Unit
(Normal)

Max Current
Value

Voltage

H

Vb

EP 2 811 533 A1

*Fig.5*

(a)

21b(21)    21a(21)                    21a(21)

Power
Consumption
(Voltage Drop)          Power Generation

(b)

Current

P2                              L3
                                   P1
                                   Voltage

                 L4

*Fig.6*

*Fig.7*

# Fig.8

# Fig.9

## INTERNATIONAL SEARCH REPORT

| | International application No. |
|---|---|
| | PCT/JP2013/051437 |

A. CLASSIFICATION OF SUBJECT MATTER
*H01L31/042*(2006.01)i, *H02H3/00*(2006.01)i, *G01R31/26*(2006.01)i

According to International Patent Classification (IPC) or to both national classification and IPC

B. FIELDS SEARCHED

Minimum documentation searched (classification system followed by classification symbols)
H01L31/042, H02H3/00, G01R31/26

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2010-506413 A (Elettronica Santerno S.p.A.), 25 February 2010 (25.02.2010), & WO 2008/043814 A1 & EP 2074438 A & KR 10-2009-0077778 A & CN 101523230 A & US 2010/0007212 A1 & RU 2009117831 A & AU 2007306333 A1 | 1-8 |
| Y | JP 9-23019 A (The Kansai Electric Power Co., Inc.), 21 January 1997 (21.01.1997), (Family: none) | 1-8 |
| Y | JP 11-274544 A (Sharp Corp.), 08 October 1999 (08.10.1999), (Family: none) | 1-8 |

☒ Further documents are listed in the continuation of Box C.　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 22 February, 2013 (22.02.13) | 05 March, 2013 (05.03.13) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2013/051437

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 2002-95154 A (Sony Corp.),<br>29 March 2002 (29.03.2002),<br>& EP 1189325 A2 & US 2002/0039270 A1 | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001024204 A